# EUROPÄISCHE PATENTSCHRIFT

(11) **EP 1 221 492 B1**
(45) Veröffentlichungstag und Bekanntmachung des Hinweises auf die Patenterteilung: **06.04.2005**
(21) Anmeldenummer: 01811212.8
(22) Anmeldetag: 12.12.2001
(51) Int. Cl.: C22C 21/06, H01L 21/00

(54) **Behälter aus einer Leichtmetalllegierung und Verfahren zu seiner Herstellung**
Light alloy container and method for its production
Alliage léger et procédé de fabrication

(30) Priorität: 29.12.2000 DE 10065264; 15.02.2001 DE 10106999
(43) Veröffentlichungstag der Anmeldung: 10.07.2002
(73) Patentinhaber: Alcan Technology & Management AG, 8212 Neuhausen am Rheinfall (CH)
(72) Erfinder: Hodel, Ulf, 78234 Engen (DE); Gitter, Reinhold, 78244 Gottmadingen (DE)
(74) Vertreter: Hiebsch, Gerhard F., Dipl.-Ing.

(56) Entgegenhaltungen:
- EP-A- 1 138 793
- PATENT ABSTRACTS OF JAPAN vol. 1998, no. 09, 31. Juli 1998 (1998-07-31) -& JP 10 088271 A (KYUSHU MITSUI ALUM KOGYO KK;TOSHIBA CORP), 7. April 1998 (1998-04-07)
- PATENT ABSTRACTS OF JAPAN vol. 013, no. 293 (C-615), 6. Juli 1989 (1989-07-06) -& JP 01 087740 A (SKY ALUM CO LTD), 31. März 1989 (1989-03-31)
- PATENT ABSTRACTS OF JAPAN vol. 013, no. 293 (C-615), 6. Juli 1989 (1989-07-06) -& JP 01 087739 A (FURUKAWA ALUM CO LTD), 31. März 1989 (1989-03-31)
- PATENT ABSTRACTS OF JAPAN vol. 018, no. 632 (C-1280), 2. Dezember 1994 (1994-12-02) -& JP 06 240395 A (SKY ALUM CO LTD), 30. August 1994 (1994-08-30)
- PATENT ABSTRACTS OF JAPAN vol. 2000, no. 25, 12. April 2001 (2001-04-12) -& JP 2001 220637 A (KOBE STEEL LTD), 14. August 2001 (2001-08-14)

## Beschreibung

Die Erfindung betrifft einen Behälter nach dem Oberbegriff des Patentanspruchs 1. Zudem erfasst die Erfindung ein Verfahren zu dessen Herstellung.

Derartige Behälter aus einer Leichtmetalllegierung sind als Innenbehälter für Prozessbehälter bei der Behandlung von Wafern bekannt, insbesondere zur Durchführung von Wafer-Ätzprozessen.

Wafer sind oblatenartig dünne Scheiben unter 0,5 mm Dicke, die aus Einkristallen von dotiertem Silizium oder anderen Halbleiterwerkstoffen geschnitten werden, um für integrierte Schaltkreise od.dgl. elektrische Bauelemente eingesetzt werden zu können. Zur Erzeugung eines Wafers werden nach dem Trennen eines Siliziumbarrens in hauchdünne Scheiben diese geläppt, geätzt und poliert.

Im Gegensatz zum Läppen, bei dem eine rotierende Ober- und Unterscheibe mittels einer Kristallkörneremulsion Material von der dazwischenliegenden Siliziumscheibe abtragen, werden beim Schleifen höhere Materialabträge sowie bessere Oberflächenqualitäten erreicht, gleichzeitig wird die sog. Kristallstörtiefe vermindert. Durch spezielle Schleifscheiben und Prozessparameter ist es möglich, an der Zerspanstelle lokal hohe Drücke und Temperaturen aufzubauen und das Silizium zu plastifizieren; Siliziumspäne können an der Oberfläche ohne Materialsausbrüche abgenommen werden.

Für die Behandlung bislang gängiger Wafer-Größen -- Durchmesser 200 mm -- werden Metallbehälter benutzt, die aus nahtlos über einen Dorn stranggepressten Rohren gefertigt werden können. Bei maximalen Rohrdurchmessern von etwa 450 mm ist diese Herstellungsweise der Behälter etwa aus AlMg 4 -- also einem Werkstoff mit hohen Mg-Gehalt für hinreichende Härte -- kostenträchtig. Die Innenfläche ist üblicherweise eloxiert; trotzdem wirken sich Legierungsbestandteile in Wafer-Fertigungsprozessen aus, dies insbesondere dann, wenn je nach Ätzmedium in der Eloxalschicht aufgrund des Angriffes von Gasen Fehlstellen entstehen oder sich vermehren. Zudem sind durch zunehmende Durchmesser der Wafer entsprechende Rohre für die Behältergestaltung nicht mehr mittels der üblichen Dornmatrize herstellbar.

Die JP-A-10 088 271 befasst sich mit einer Aluminiumlegierung, die u. a. für eine Plasmakammer eingesetzt werden kann. Die Aluminiumlegierung enthält 0,2 bis 1,0 Gew.-% Si und 0,35 bis 2,5 Gew-% Mg, wobei letzteres in einer Menge > 1,73 x Si vorliegt. Die Verunreinigungen -- außer Mg und Si -- sollen nicht mehr als 0,1 Gew.-% betragen. Am Rande wird hier sinngemäß erwähnt, dass Si-Wafers bei Plasmabehandlung unter Si-Einfluss zu Verunreinigungen neigen.

Der EP-A-1 138 743 ist eine für spanabhebende Formgebung geeignete hochreine Aluminiumlegierung zu entnehmen, die neben Aluminium als Legierungsbestandteil 1,4 bis 2,9 % Magnesium aufweist. Alle weiteren Elemente, also die Verunreinigungen, sind in der Summe mit bis zu maximal 300 ppm begrenzt, ihre Konzentration -- bis auf Aluminium und Magnesium -- beträgt maximal 40 ppm. Der Gasgehalt ist begrenzt mit maximal 0,25 ppm. Bauteile aus dieser Legierung können durch Anodisieren mit extrem korrosionsbeständigen Schichten versehen werden. Durch zusätzliches Verdichten der Oberfläche der erzeugten Bauteile aus dieser Legierung -- z. B. durch Sand- bzw. Kugelstrahlen -- kann die Korrosionsbeständigkeit der Anodisierung weiter günstig beeinflusst werden. Diese Schrift enthält auch einen Hinweis auf Bauteile großer Abmessung, die durch Strangpressen eines Gusskörpers entstehen sollen.

Angesichts dieser Gegebenheiten hat sich der Erfinder das Ziel gesetzt, die Herstellbarkeit solcher Metallbehälter zu verbessern und zudem ihre Haltbarkeit zu erhöhen.

Zur Lösung dieser Aufgabe führt die Lehre des unabhängigen Anspruches; die Unteransprüche geben günstige Weiterbildungen an. Zudem fallen in den Rahmen der Erfindung alle Kombinationen aus zumindest zwei der in der Beschreibung, der Zeichnung und/oder den Ansprüchen offenbarten Merkmale.

Dabei wird die rohrartige Behälterwandung aus einem metallischen Werkstoff hergestellt, wobei der eingesetzte Werkstoff auf Aluminiumbasis einen Magnesiumgehalt zwischen 1,2 und 2,0 Gew.-% aufweist bei äußerst geringen Anteilen von Cu, Fe, Si in der Größenordnung unter 0,5 Gew.-%.

Man setzt für die Produktion -- auf dem Wege des Strangpressens -- vorteilhafterweise eine im Verfahren preisgünstige Spezialmatrize für Rohre ein, dazu jedoch -- anstelle des traditionellen, zusammen mit Spezialmatrizen verwendeten Legierungsmaterials AlMgSi -- einen diesbezüglichen neuen Legierungswerkstoff, nämlich das erwähnte AlMgX, dessen Anteil "X" -- wie gesagt -- zwischen 1,2 und 2,0 Gew.-% liegt und das insbesondere weder Si noch Cu oder Fe in beachtenswerter Menge enthält.

Durch den Verzicht auf einen Anteil von beispielsweise 0,8 Gew.-% Si beim neuen Verfahren mittels Spezialmatrize entsteht der bei Spezialmatrizen an sich zu erwartende Aushärteeffekt durch Koagulation intermetallischer Phasen nicht mehr. Stattdessen wird ein alternativer Härteeffekt erreicht, indem der Magnesium-Gehalt angehoben wird. Das Vorurteil der Fachwelt, dass Großrohre nur über eine Matrize mit Mg und Si in der Legierung herstellbar sind, trifft erkennbar nicht zu.

Im Ergebnis läßt sich ein hinreichend gut verschweissbares Rohr herstellen, das zudem noch ausreichend fest für die -Behälter-Fertigung sowie den beschriebenen Einsatz ist, nicht jedoch die im Wafer-Herstellungsprozess störenden Si und Fe enthält.

Weitere Vorteile, Merkmale und Einzelheiten der Erfindung ergeben sich aus der nachfolgenden Beschreibung eines bevorzugten Ausführungsbeispieles sowie anhand der Zeichnung; diese zeigt skizzenhaft in:
- Fig. 1:: eine Draufsicht auf eine Herstellungsstation für die Waferbehandlung;
- Fig. 2:: eine Schrägsicht auf einen -- teilweise geschnittenen -- Innenbehälter für einen nicht gezeigten Prozessbehälter zur Wafer-Behandlung, insbesondere für Wafer-Ätzprozesse.

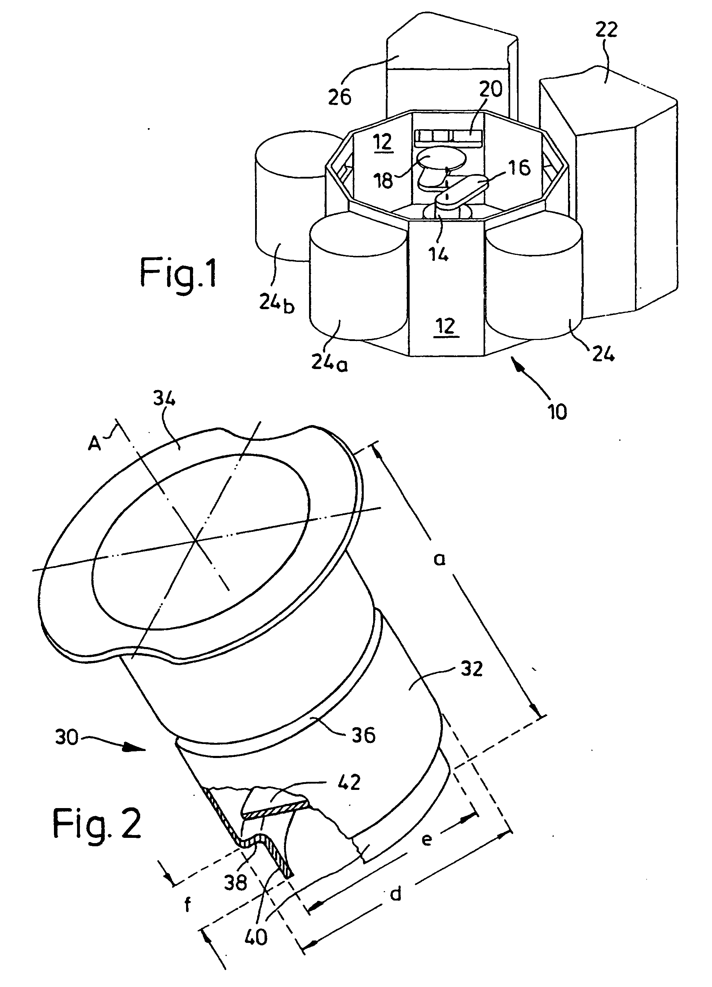

Zur Waferbehandlung dient nach Fig. 1 ein querschnittlich polygones Gefäß 10 aus hier zehn Wandabschnitten 12 mit an einer zentralen Welle 14 gelagertem Tragarm aus mehreren aneinandergelenkten Armabschnitten 16 für eine Tragscheibe 18 für einen nicht gezeigten Wafer. Dieser wird durch Wandschlitze 20 zum einen einer Abgabestation 22 entnommen und in Bearbeitungsstationen 24, 24ₐ, 24_{b} Ätz- und Reinigungsprozessen unterworfen sowie anschließend einer Abnahmestation 26 zugeführt.

Benötigt wird dazu auch der erwähnte Prozessbehälter, dessen Innenbehälter 30 an einem zylindrischen -- in anderen Ausgestaltungen auch polygonen -- Rohrkörper als Behälterwandung 32 des Außendurchmessers d von beispielsweise 450 mm einends einen angeformten Radialkragen 34 als Stützelement aufweist. Etwa in der Mitte seiner zur Längsachse A parallelen halben Länge a ist der Rohrkörper bzw. die Behälterwandung 32 mit einer nutförmigen Ringeinformung 36 ausgestattet sowie an seinem dem Radialkragen 34 fernen Ende -- dank einer radialen Stufung 38 -- mit einem ebenfalls angeformten -- Mündungsring 40 des Außendurchmessers e von hier 400 mm. Die axiale Länge f des Mündungsringes 20 entspricht etwas mehr als einem Sechstel jener Länge a des ihn erfassenden Rohrkörpers 32. An der radialen Stufung 38 ist bei 42 eine Bodenplatte angedeutet.

Der Innenbehälter 30 wird aus einem Legierungswerkstoff AlMgX geformt; dessen Anteil von "X" in der Legierung zwischen 1,2 und 2,0 Gew.-% liegt. Diese Legierung enthält die Elemente Cu, Fe, Si, allenfalls in einer Größenordnung von Verunreinigungen.

## Patentansprüche

1. Behälter aus einer Leichtmetalllegierung auf Aluminium-basis zum Einsatz als Reaktionskammer in einem Bearbeitungsprozess für Wafer, wobei
die rohrartige Behälterwandung (32) zum Einsatz bei Wafer-Ätzprozessen mit einem Magnesiumgehalt zwischen 1,2 und 2,0 Gew.-% hergestellt ist, wobei die Elemente Cu, Fe, Si in Anteilen unter 0,5 Gew.-% enthalten sind, und der Rest Aluminium und die unvermeidlichen Verunreinigungen ist, **dadurch gekennzeichnet, dass** in dem Behälter (30) eine Bodenplatte (42) vorhanden ist, wobei
in der Behälterwandung (32) einends eine radiale Stufung (38) für die auf diese auflegbare Bodenplatte (42) des Behälters (30) ausgeformt ist und wobei die Behälterwandung (32) auf dem Wege des Strangpressens geformt ist.

2. Behälter nach Anspruch 1, **dadurch gekennzeichnet, dass** an die radiale Stufung (38) ein Mündungsring (40) angeformt ist.

3. Behälter nach einem der Ansprüche 1 oder 2, **dadurch gekennzeichnet, dass** er an seinem der Bodenplatte fernen Ende mit einem angeformten Radialkragen (34) versehen ist.

4. Behälter nach einem der Ansprüche 1 bis 3, **dadurch gekennzeichnet, dass** die Behälterwandung (32) etwa in der Mitte ihrer zur Längsachse (A) parallelen halben Länge (a) mit einer nutförmigen Ringeinformung (36) ausgestattet ist.

5. Verfahren zur Herstellung eines Behälters nach einem der Ansprüche 1 bis 4, **dadurch gekennzeichnet, dass** die Behälterwandung (32) in einer Spezialmatrize stranggepresst wird.

## Claims

1. Container made from a light metal alloy based on aluminium for use as a reaction chamber in a treatment process for wafers, wherein the tubular container wall (32) is produced for use in wafer etching processes having a magnesium content between 1.2 and 2.0 wt.%, wherein the elements Cu, Fe, Si are present in proportions below 0.5 wt.%, and the remainder is aluminium and the unavoidable impurities, **characterised in that** a base plate (42) is present in the container (30), wherein a radial gradation (38) for the base plate (42) of the container (30) which can be placed on the latter is shaped in the container wall (32) at one end and wherein the container wall (32) is shaped by way of extrusion.

2. Container according to claim 1, **characterised in that** a neck ring (40) is moulded onto the radial gradation (38).

3. Container according to one of claims 1 or 2, **characterised in that** it is provided with a moulded-on radial collar (34) at its end remote from the base plate.

4. Container according to one of claims 1 to 3, **characterised in that** the container wall (32) is provided with a groove-like annular mould (36) approximately in the centre of half its length (a) parallel to the longitudinal axis (A).

5. Process for producing a container according to one of claims 1 to 4, **characterised in that** the container wall (32) is extruded in a special die.

## Revendications

1. Récipient en un alliage de métal léger à base d'aluminium pour l'utilisation comme chambre réactionnelle dans un procédé de transformation pour des tranches, dans lequel la paroi du récipient de type cylindrique (32) est fabriquée pour l'utilisation dans des procédés de gravures de tranches avec une teneur en magnésium entre 1,2 et 2,0 % en poids, les éléments Cu, Fe, Si étant présents en des proportions inférieures à 0,5 % en poids et le reste étant constitué d'aluminium et des impuretés inévitables, **caractérisé en ce qu'**une plaque de fond (42) est présente dans le récipient (30), dans lequel un palier radial (38), pour que la plaque de fond (42) du récipient (30) puisse y être posée dessus, est formé dans la paroi du récipient (32) et dans lequel la paroi du récipient (32) est formée au moyen du filage.

2. Récipient selon la revendication 1, **caractérisé en ce qu'**un anneau d'embouchure (40) est formé contre le palier radial (38).

3. Récipient selon l'une des revendications 1 ou 2, **caractérisé en ce qu'**il est doté, sur son extrémité opposée à la plaque de fond, d'un col radial aménagé (34).

4. Récipient selon l'une des revendications 1 à 3, **caractérisé en ce que** la paroi du récipient (32) est munie, environ au milieu de sa demie longueur (a) parallèle à l'axe longitudinal (A), d'un moulage circulaire en forme de rainure (36).

5. Procédé de fabrication d'un récipient selon l'une des revendications 1 à 4, **caractérisé en ce que** la paroi du récipient (32) est filée dans une matrice spéciale.
